# EUROPEAN PATENT SPECIFICATION

(11) **EP 3 549 176 B1**
(45) Date of publication and mention of the grant of the patent: **29.07.2026**
(21) Application number: 19732528.5
(22) Date of filing: 02.01.2019
(51) Int. Cl.: H10F 30/221, H10F 30/223, H10F 39/18, H10F 77/40

(54) **GERMANIUM BASED FOCAL PLANE ARRAY FOR THE SHORT INFRARED SPECTRAL REGIME**
VERSCHLECHTERUNGSSCHÄTZVORRICHTUNG FÜR EINE ENERGIEUMWANDLUNGSVORRICHTUNG
RÉSEAU PLAN FOCAL À BASE DE GERMANIUM POUR LE RÉGIME SPECTRAL INFRAROUGE COURT

(30) Priority: 09.01.2018 US 201862615198 P
(43) Date of publication of application: 09.10.2019
(73) Proprietor: Trieye Ltd., 6789155 Tel Aviv (IL)
(72) Inventor: LEVY, Uriel, 5552507 Kiryat Ono (IL); BAKAL, Avraham, 6299111 Tel Aviv (IL); KAPACH, Omer, 9738008 Jerusalem (IL)
(74) Representative: Kasche & Partner
(86) International application number: PCT/IB2019/050030
(87) International publication number: WO 2019/138301

(56) References cited:
- WO-A1-2018/211354
- US-A- 4 541 000
- US-A1- 2009 324 164
- US-A1- 2017 294 550
- US-B2- 8 178 382
- US-B2- 8 809 672
- US-B2- 9 812 598
- SCHMELZ D. ET AL: "Optical modeling of Ge-on-Si focal plane arrays with diffractive light coupling", PROCEEDINGS IRS2 2017, 1 January 2017 (2017-01-01), pages 761 - 765, XP055815719, DOI: 10.5162/irs2017/i1.5
- NIBIR K. DHAR ET AL: "Advanced imaging research and development at DARPA", SPIE PROCEEDINGS, vol. 8353, 23 April 2012 (2012-04-23), US, pages 835302 - 835302-9, XP055695472, ISBN: 978-1-5106-3673-6, DOI: 10.1117/12.923682
- HUI CONG ET AL: "Chinese Physics B High-speed waveguide-integrated Ge/Si avalanche photodetector *", CHIN. PHYS. B, vol. 25, no. 5, 31 March 2016 (2016-03-31), pages 058503-1 - 058503-4, XP055641932
- STERN A.G. ET AL: "Design of a back-illuminated, crystallographically etched, silicon-on-sapphire avalanche photodiode with monolithically integrated microlens, for dual-mode passive & active imaging arrays", PROC. SPIE, LIDAR REMOTE SENSING FOR ENVIRONMENTAL MONITORING IX, vol. 7153, 71530Z, 9 December 2008 (2008-12-09), pages 1 - 13, XP040446072, DOI: 10.1117/12.804846
- MOTAMEDI M E ET AL: "MICRO-OPTIC INTEGRATION WITH FOCAL PLANE ARRAYS", OPTICAL ENGINEERING, SOC. OF PHOTO-OPTICAL INSTRUMENTATION ENGINEERS, BELLINGHAM, vol. 36, no. 5, May 1997 (1997-05-01), pages 1374 - 1379, XP000692368, ISSN: 0091-3286, DOI: 10.1117/1.601347
- ROGALSKI A ED - SKARBEK WLAD: "Optical detectors for focal plane arrays", OPTO-ELECTRONICS REVIEW, WARSZAWA, PL, vol. 12, no. 2, 2004, pages 221 - 245, XP002393167, ISSN: 1230-3402
- JIFENG LIU: "Monolithically Integrated Ge-on-Si Active Photonics", PHOTONICS, vol. 1, no. 3, 2 July 2014 (2014-07-02), pages 162 - 197, XP055353773, DOI: 10.3390/photonics1030162

## Description

### CROSS REFERENCE TO RELATED APPLICATIONS

This application claims the benefit of priority from U.S. Provisional patent application No. 62615198 filed January 9, 2018.

### FIELD

Embodiments disclosed herein relate in general to focal plane arrays (FPAs) in the the short wave infrared (SWIR) spectral regime, and in particular to a method for forming such FPAs based on Germanium (Ge) detectors.

### BACKGROUND

Imaging systems operating in the SWIR (generally defined to be between about 1000-2500 nm wavelength) are attracting growing attention due to numerous reasons. For example, compared to visible range, light in SWIR range is less sensitive to extreme weather conditions such as fog and dust. Moreover, the SWIR wavelength range is invisible to the human eye. Additionally, eye safety regulations allow use of high power active illumination sources in the SWIR range. Such advantages, combined with the fact that unlike in thermal imaging the image contrast mechanisms for SWIR resemble that of the visible range, thus allowing use of conventional image recognition algorithms, render the SWIR regime an attractive alternative to the visible range for imaging purposes.

Known FPAs in the SWIR range are typically made using the InGaAs material system. While the performance envelope of InGaAs based FPAs is attractive, the cost of such FPAs is high, preventing their use in many consumer market applications.

There is a need for, and it would be advantageous to have, SWIR photodetectors and FPAs based on silicon and other group IV materials, providing high performance at low cost, and methods to fabricate such SWIR photodetectors and FPAs.

Hui Cong ET AL: "Chinese Physics B High-speed waveguide-integrated Ge/Si Avalanche photodetector", Chin. Phys. B, vol. 25, no 5, 31 March 2016, pages 058503-1 to 4, (**D1**), discloses (Abstract): Waveguide-integrated Ge/Si heterostructure avalanche photodetectors (APDs) were designed and fabricated using a CMOS-compatible process on 8-inch SOI substrate. The structure of the APD was designed as separate-absorption-charge-multiplication (SACM) using germanium and silicon as absorption region and multiplication region, respectively. The breakdown voltage (*V* _{b}) of such a device is 19 V at reverse bias and dark current appears to be 0.71 µA at 90% of the *V* _{b}. The device with a 10-µm length and 7-µm width of Ge layer shows a maximum 3-dB bandwidth of 17.8 GHz at the wavelength of 1550 nm. For the device with a 30-µm-length Ge region, gain-bandwidth product achieves 325 GHz.

US2009/324164 discloses (**D2**): Embodiments of the present invention describe a waveguide-based photodetector device and its methods of fabrication. The waveguide photodetector device comprises a substrate having a cladding structure formed thereon. A waveguide element for receiving optical signals is disposed within the cladding structure. A portion of the waveguide element is encapsulated by a photodetector element that detects the optical signal received by the waveguide element and generates an electrical signal based on the optical signal. Encapsulating the waveguide element in the photodetector element improves coupling efficiency and enables a waveguide photodetector device with higher speeds and higher responsivity.

Stern A. G. et al.: «Design of a back-illuminated, crystallographically etched, silicon-on-sapphire avalanche photodiode with monolithically integrated microlens, for dual-mode passive & active imaging arrays", PROC, SPIE, vol. 7153, 71530Z, 9 December 2009, p. 1-13, (**D3**), discloses (Abstract): There is a growing need in space and environmental research applications for dual-mode, passive and active 2D and 3D ladar imaging methods. To fill this need, an advanced back-illuminated avalanche photodiode (APD) design is presented based on crystallographically etched (100) epitaxial silicon on R-plane sapphire (SOS), enabling single photon sensitive, solid-state focal plane arrays (FPAs) with wide dynamic range, supporting passive and active imaging capability in a single FPA. When (100) silicon is properly etched with KOH:IPA:H2O solution through a thermally grown oxide mask, square based pyramidal frustum or mesa arrays result with the four mesa sidewalls of the APD formed by (111) silicon planes that intersect the (100) planes at a crystallographic angle, Φc = 54.7°. The APD device is fabricated in the mesa using conventional silicon processing technology. Detectors are back-illuminated through light focusing microlenses fabricated in the thinned, AR-coated sapphire substrate. The APDs share a common, front-side anode contact, made locally at the base of each device mesa. A low resistance (Al) or (Cu) metal anode grid fills the space between pixels and also inhibits optical cross-talk. SOS-APD arrays are indium bump-bonded to CMOS readout ICs to produce hybrid FPAs. The quantum efficiency for the square 27 µm pixels exceeds 50% for 250 nm ≤ λ < 400 nm and exceeds 80% for 400 nm < λ < 700 nm. The sapphire microlenses compensate detector quantum efficiency loss resulting from the mesa geometry and yield 100% sensitive-area-fill-factor arrays, limited in size only by the wafer diameter.

US4541000A (**D4**) discloses (Abstract): A varactor or mixer diode comprises a mesa shaped semiconductor element having a p-n junction barrier layer or retifying junction on its upper face and a substrate contact on its opposite face, the substrate contact extending over the side faces of the semiconductor element and ending at a small spacing from the barrier layer or junction.

Motamedi ME: "Micro-optic integration with focal plane arrays", Optical Engineeering, vol. 36, no. 5, May 1997, pages 1374-1379, (**D5**), discloses(Abstract): There is a growing need in space and environmental research applications for dual-mode, passive and active 2D and 3D ladar imaging methods. To fill this need, an advanced back-illuminated avalanche photodiode (APD) design is presented based on crystallographically etched (100) epitaxial silicon on R-plane sapphire (SOS), enabling single photon sensitive, solid-state focal plane arrays (FPAs) with wide dynamic range, supporting passive and active imaging capability in a single FPA. When (100) silicon is properly etched with KOH:IPA:H₂O solution through a thermally grown oxide mask, square based pyramidal frustum or mesa arrays result with the four mesa sidewalls of the APD formed by (111) silicon planes that intersect the (100) planes at a crystallographic angle, Φc = 54.7°. The APD device is fabricated in the mesa using conventional silicon processing technology. Detectors are back-illuminated through light focusing microlenses fabricated in the thinned. AR-coated sapphire substrate. The APDs share a common, front-side anode contact, made locally at the base of each device mesa. A low resistance (Al) or (Cu) metal anode grid fills the space between pixels and also inhibits optical cross-talk. SOS-APD arrays are indium bump-bonded to CMOS readout ICs to produce hybrid FPAs. The quantum efficiency for the square 27 µm pixels exceeds 50% for 250 nm < λ < 400 nm and exceeds 80% for 400 nm < λ < 700 nm. The sapphire microlenses compensate detector quantum efficiency loss resulting from the mesa geometry and yield 100% sensitive-area-fill-factor arrays, limited in size only by the wafer diameter.

Rogalski A Ed - Skarbek Wlad: "Optical detectors for focal plane arrays", Opto-Electronics Review, Warszawa, PL, vol. 12, no. 2, 2004, pages 221-245, (**D6**), discloses (Conclusions): This paper reviews optical detector focal plane array tech-nology with emphasis on the past 25 years. Discussion isfocused mainly on current and the most rapidly developingdetectors: CdZnTe detectors, AlGaN photodiodes, visibleCCD and CMOS imaging systems. HgCdTe heterostructure photodiodes, quantum well AlGaAs/GaAs photocon-ductors, and thermal detectors. It is shown that in the spec-tral range from X ray to far infrared the rate at which im-ages can be acquired has increased by more than a factor ofa million in many cases. Even in visible region, the detec-tor arrays are gradually replacing film as the capabilitiesand popularity of digital camera grow. The second aspect of presentation devotes trends in fo-cal plane array technology.

Examples of arrays and imagersare chosen to illustrate the current state and art. All considerations are carried out in historical aspects. This paper offers a rather wide coverage of optical detector technology. However, for a full understanding of thetechnical content, the paper requires as a prerequisite thebasic courses in material science and fundamentals of semiconductor physics

Jifeng Liu: "Monolithically Integrated Ge-on-Si Active Photonics", Photonics, vol. 1, no. 3, 2 July 2014, pages 162-197, (**D7**), discloses: Monolithically integrated, active photonic devices on Si are key components in Si-based large-scale electronic-photonic integration for future generations of high-performance, low-power computation and communication systems. Ge has become an interesting candidate for active photonic devices in Si photonics due to its pseudo-direct gap behavior and compatibility with Si complementary metal oxide semiconductor (CMOS) processing. In this paper, we present a review of the recent progress in Ge-on-Si active photonics materials and devices for photon detection, modulation, and generation. We first discuss the band engineering of Ge using tensile strain, n-type doping, Sn alloying, and separate confinement of Γ vs. L electrons in quantum well (QW) structures to transform the material towards a direct band gap semiconductor for enhancing optoelectronic properties. We then give a brief overview of epitaxial Ge-on-Si materials growth, followed by a summary of recent investigations towards low-temperature, direct growth of high crystallinity Ge and GeSn alloys on dielectric layers for 3D photonic integration. Finally, we review the most recent studies on waveguide-integrated Ge-on-Si photodetectors (PDs), electroabsorption modulators (EAMs), and laser diodes (LDs), and suggest possible future research directions for large-scale monolithic electronic-photonic integrated circuits on a Si platform.

Schmelz D. ET AL: "Optical modeling of Ge-on-Si focal plane arrays with diffractive light coup|lng", Proceedings IRS2 2017, p. 761-765, XPO55815719, disclose (Abstract): Coupling light via stochastic needle-like nanostructures (black silicon) on the back side of a Ge-on-Si photodiode provides an increase of light absorption (and thus of the quantum efficiency) while preserving the f3dB-bandwidth of the diode [1, 2]. When transferring this technique from a single photodiode to array-like devices such as focal plane arrays (FPAs), it comes to optical crosstalk in adjacent pixels. A simulation model based on the ray tracing program Zemax can determine the absorption in Ge-on- Si FPAs under arbitrary illumination. It simulates the absorption in every individual pixel and thus enables the calculation of optical crosstalk, as well as the total absorption, as functions of different design parameters. It gives the opportunity to compile parameter surveys or to perform a design optimization of the array device. The simulation model can be easily adapted to similar applications, thus providing a wide range of usage.

Nibir K. Dhar ET AL: "Advanced imaging research and development at DARPA", SPIE Proceedings, vol. 8353, 23 April 2012, p. 835302, XP055695472 disclose (Abstract): Advances in imaging technology have huge impact on our daily lives. Innovations in optics, focal plane arrays (FPA), microelectronics and computation have revolutionized camera design. As a result, new approaches to camera design and low cost manufacturing is now possible. These advances are clearly evident in visible wavelength band due to pixel scaling, improvements in silicon material and CMOS technology. CMOS cameras are available in cell phones and many other consumer products. Advances in infrared imaging technology have been slow due to market volume and many technological barriers in detector materials, optics and fundamental limits imposed by the scaling laws of optics. There is of course much room for improvements in both, visible and infrared imaging technology. This paper highlights various technology development projects at DARPA to advance the imaging technology for both, visible and infrared. Challenges and potentials solutions are highlighted in areas related to wide field-of-view camera design, small pitch pixel, broadband and multiband detectors and focal plane arrays.

### SUMMARY

The invention is set out in the appended set of claims.

Embodiments disclosed herein relate to low cost, high performance light detecting structures for detecting light in the SWIR regime, and methods for fabricating such structures.

In exemplary embodiments, there are provided light detecting structures comprising a Si base having a pyramidal shape with a wide incoming light-facing pyramid bottom and a narrower pyramid top, and Ge photodiode formed on the Si pyramid top, wherein the Ge photodiode is operable to detect light in the SWIR range.

In an exemplary embodiment, the Ge photodiode includes a p-n junction.

In an exemplary embodiment, the Ge photodiode includes a p-i-n junction.

In an exemplary embodiment, a light detecting structure described above or below further comprises a microlens placed between the pyramid bottom and the incoming light.

In an exemplary embodiment, a light detecting structure described above or below further comprises an anti-reflection layer positioned between the pyramid bottom and the microlens.

In an exemplary embodiment, the pyramid bottom is a square of about 10 x 10 micrometer squared (µm²). In an exemplary embodiment, the pyramid bottom is a square of about 20 x 20 µm².

In an exemplary embodiment, the pyramid top is a square of about 1 x 1 µm². In an exemplary embodiment, the pyramid top is a square between about 1 x 1 µm² to about 10 x10 µm².

In an exemplary embodiment, a light detecting structure described above or below is repeated spatially to provide a plurality of Ge photodiodes formed on respective Si pyramid tops to form a FPA.

### BRIEF DESCRIPTION OF THE DRAWINGS

Non-limiting examples of embodiments disclosed herein are described below with reference to figures attached hereto that are listed following this paragraph. Identical structures, elements or parts that appear in more than one figure are generally labeled with a same numeral in all the figures in which they appear. The drawings and descriptions are meant to illuminate and clarify embodiments disclosed herein, and should not be considered limiting in any way. In the drawings:
FIG. 1 illustrates schematically in a side view an embodiment of a Ge-based photosensitive structure disclosed herein;
FIG. 2 illustrates schematically main steps in a method of fabricating a Ge-based FPA disclosed herein.

### DETAILED DESCRIPTION

In the following detailed description, numerous specific details are set forth in order to provide a thorough understanding. However, it will be understood by those skilled in the art that the presently disclosed subject matter may be practiced without these specific details. In other instances, well-known methods have not been described in detail so as not to obscure the presently disclosed subject matter.

It is appreciated that certain features of the presently disclosed subject matter, which are, for clarity, described in the context of separate embodiments, may also be provided in combination in a single embodiment. Conversely, various features of the presently disclosed subject matter, which are, for brevity, described in the context of a single embodiment, may also be provided separately or in any suitable sub-combination.

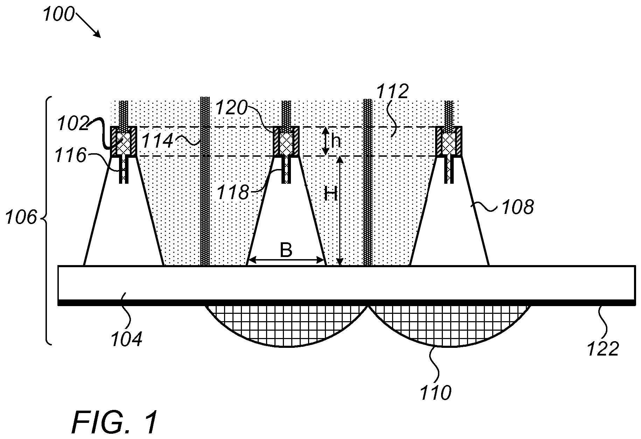

FIG. 1 illustrates schematically in a side view an embodiment of a Ge-based photosensitive (PS) structure disclosed herein, numbered **100.** Structure **100** includes a layer **102** of a Ge absorbing medium grown on a doped Si substrate (wafer) **104,** a light collecting structure **106** including silicon pyramids **108** integrally formed in the Si wafer, an insulating oxide **112** that fills the gap between adjacent pyramids **108,** and electrically conductive contacts **114** for electrically connecting one or more Ge photodetectors (also referred to next as " Ge photodiode" or simply "Ge diode") **120** to the outside world. FIG. 1 also shows a growth seed **116** etched into the silicon substrate to support crystalline growth of the Ge layer and to trap threading dislocations (not shown). The trapping prevents the dislocations from propagating into the Ge layer above the seed, thus improving the quality of the Ge layer. The seed is protected by a thin oxide layer **118** on all sides except at its bottom, which is exposed to the growth chemistry. This is done to ensure that the Ge crystalline growth originates from the bottom of the seed.

In more detail, each Si pyramid **108** is formed with a large base "B" on wafer **104.** The base may have a square shape with exemplary dimensions of 10 x10 µm² or more, e.g. up to 20 x 20 µm². The square shape and the dimensions of the pyramid top are exemplary, and other shapes (for example rectangular) or dimensions are possible. Ge diode **120** (e.g. with a p-n structure or a p-i-n structure) is formed on a narrower top of the pyramid. Each pyramid collects light impinging on the large base (B) and confines the light to the smaller dimension of the Ge diode. For example, the Ge diode has lateral dimensions from about 1 µm to a few (e.g. about 2, 3, 4 and even 10) µm. The thickness of the Ge layer h may be about 1 µm or larger and is chosen such that significant absorption (e.g. larger than 30% at a 1500 nm wavelength) of SWIR light is achieved. Since the size of the Ge diode is small compared to that of the Si pyramid base, the dark current component, which is proportional to the volume of the absorption media, is greatly reduced. An array of microlenses **110** can optionally be placed below the pyramids to further improve the light collection efficiency. An anti-reflection layer (AR) **122** can optionally be added to reduce the reflection of light impinging on the FPA.

In operation, light propagates through each Si pyramid **108,** which is transparent in the SWIR wavelength range. As the light arrives at the top of the Si pyramid, it penetrates into Ge diode **120.** The light absorbed by the Ge layer generates electron-hole pairs, which are separated by the diode structure under the application of reverse bias or even without bias in well-known ways, resulting in useful photocurrent that provides photo detection.

A structure comprising one Si pyramid with the Ge diode on top and surrounded by oxide may be considered to be a single "active pixel". This structure may be repeated spatially many times, to provide an array of active pixels that thus form the photosensitive wafer of the FPA.

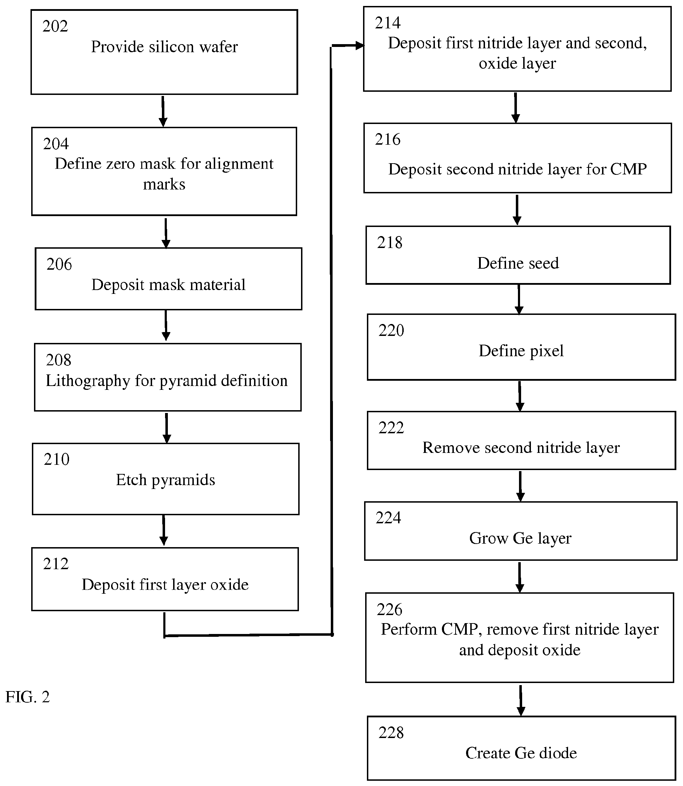

FIG. 2 illustrates schematically main steps in a method of fabricating a Ge-based FPA disclosed herein. In step **202,** a silicon wafer with {100} crystallographic plane orientation, preferably double polished, is provided as a starting material. The wafer is provided with a thin oxide (~10 nm oxide thickness) that protects the surface of the silicon from the following lithography process. In step **204,** lithography and etching are performed to define alignment marks in the silicon. In step **206,** a pyramid pattern mask is defined, e.g. by depositing a first thin silicon nitride layer (or any other layer that can be used as a mask for etching process) on top of the thermally grown oxide. In step **208,** the dimensions of the pyramid base are defined (e.g. as square shapes from about 10x10 µm² and up to about 20 x 20 µm²) using photolithography and etching of the silicon nitride layer. The silicon pyramids may be created in step **210** either by anisotropic etching with potassium hydroxide (KOH) solution or by reactive ion etching (RIE), the latter achieved by controlling the RIE parameters in a known way to provide the desired profile. In step **212,** a thick silicon oxide layer is deposited (e.g. using plasma enhanced chemical vapor deposition (CVD)) to fill the voids between the pyramids. The structure is planarized, e.g. by chemical mechanical polishing (CMP) such that the oxide is planar with the top of the silicon pyramid. In step **214,** a second thin layer of nitride deposition, followed by a second step of oxide deposition is performed up to the desired thickness of the Ge diode (h in FIG. 1). In step **216,** a third thin nitride layer is deposited after the oxide deposition to provide selectivity in in a following CMP process. This third nitride layer is typically thicker than the second nitride layer. In step **218,** the growth seed pattern is defined. First, the seed structure is created by performing lithography and etching through the third nitride, oxide and second nitride layers and down into the silicon (e.g. about 1µm into the silicon). A typical width of the seed can range from few hundreds of nanometers to about 1µm. In step **220,** the lateral dimensions of the Ge diode are defined by performing lithography and etching to remove the third nitride layer and the oxide below it.

Next, the sidewalls of the seed are protected by performing a short oxidation step, followed by RIE, which exposes the bottom of the seed. In step **222,** the second nitride layer of each pixel is removed by RIE of by wet chemical etching without the need to use a lithographic mask. As a result, some of the third nitride is also removed. However, since the third nitride layer was thicker than the second nitride layer, some of it still remains and is used later on as a stop layer for the CMP process.

In step **224,** the Ge layer is grown using for example known CVD processes, see e.g. "Germanium epitaxy on silicon", Sci. Technol. Adv. Mater. 15 (2014) 024601. In step **226,** another CMP process is performed to planarize the Ge layer. The nitride layer is removed, and a few micrometers of oxide are deposited for passivation and for preparation for metallization. In step **228,** the Ge diodes are defined by creating a pn junction or p-i-n junction using standard processes of doping, e.g. ion implantation or diffusion and dopant activation, see e.g. "Waveguide-integrated vertical pin photodiodes of Ge fabricated on p+ and n+ Si-on-insulator layers" Japanese Journal of Applied Physics 56, 04CH05 (2017) for p-i-n, and "High-Performance Ge p-n Photodiode Achieved With Pre annealing and Excimer Laser Annealing" IEEE Photonics Technology Letters (Vol. 27, Issue 14, pp. 1485-1488 (2015 ) for pn.

In an exemplary embodiment, the doping of the central region of the Ge photodetector can be n type, where the surrounding highly doped regions are p+ doped. Alternatively, the doping polarity can be reversed, where the as-grown bulk Ge is p type, while the surrounding of the Ge diode is n+ doped. The doping is followed by contact definition and metallization to complete the Ge diodes array (i.e. the FPA).

While this disclosure has been described in terms of certain embodiments and generally associated methods, alterations and permutations of the embodiments and methods will be apparent to those skilled in the art. The disclosure is to be understood as not limited by the specific embodiments described herein, but only by the scope of the appended claims.

Unless otherwise stated, the use of the expression "and/or" between the last two members of a list of options for selection indicates that a selection of one or more of the listed options is appropriate and may be made.

It should be understood that where the claims or specification refer to "a" or "an" element, such reference is not to be construed as there being only one of that element.

## Claims

1. A light detecting structure (100) comprising:
a) a silicon (Si) base (108) having a pyramidal shape with a wide incoming light-facing pyramid bottom and a narrower pyramid top; and
b) a germanium (Ge) photodiode (120) formed only on the pyramid top, wherein the Ge photodiode is operable to detect light in the short wavelength infrared (SWIR) range; wherein the light detecting structure is repeated spatially to provide a plurality of Ge photodiodes formed on respective pyramid tops to form a focal plane array (FPA) (100).

2. The light detecting structure (100) of claim 1, wherein the Ge photodiode includes a p-n junction.

3. The light detecting structure (100) of claim 1, wherein the Ge photodiode includes a p-i-n junction.

4. The light detecting structure (100) of claim 1, wherein the pyramid bottom is a square of about 10 x 10 µm².

5. The light detecting structure (100) of claim 1, wherein the pyramid top is a square of about 1 x 1 µm².

6. The light detecting structure (100) of claim 1, wherein the pyramid bottom is a square of about 10 x 10 µm² and wherein the pyramid top is a square of about 1 x 1 µm².

7. The light detecting structure (100) of claim 1, wherein the SWIR range includes a wavelength range from about 1000nm to about 1700nm.

8. The light detecting structure of claim 1, further comprising an array of microlenses (110) placed between the pyramid bottoms and the incoming light.

9. The light detecting structure (100) of claim 8, further comprising an anti-reflection layer (122) positioned between the pyramid bottom and the array of microlenses (110).

10. The light detecting structure (100) of any of the preceding claims, wherein the size of the Ge photodiode is small compared to the Si pyramid base.

11. A method, of forming a light detecting structure, the method comprising:
a) forming a silicon (Si) base (108) having a pyramidal shape with a wide incoming light-facing pyramid bottom and a narrower pyramid top; and
b) forming a germanium (Ge) photodiode (120) only on the pyramid top, wherein the Ge photodiode is operable to detect light in the short wavelength infrared (SWIR) range;
c) providing a plurality of spatially repeated Ge photodiodes (120) formed on respective pyramid tops to form a focal plane array (FPA) (100).

12. The method of claim 11, wherein the forming a Ge photodiode (120) only on the pyramid top includes forming a Ge photodiode wherein the size of the Ge photodiode (120) is small compared to that of the Si pyramid bottom.

13. The method of claim 11, further comprising placing an array of microlenses (110) below the pyramids.

## Patentansprüche

1. Lichtdetektionsstruktur (100), umfassend:
a) eine Silizium (Si)-Basis (108), die eine Pyramidenform mit einem breiten, dem einfallenden Licht zugewandten Pyramidenboden und einem schmaleren Pyramidenoberteil aufweist; und
b) eine Germanium-, (Ge)-Photodiode (120), die nur auf dem Pyramidenoberteil gebildet ist, wobei die Ge-Photodiode betreibbar ist, um Licht im kurzwelligen Infrarotbereich (SWIR) zu detektieren;
wobei die Lichtdetektionsstruktur räumlich wiederholt wird, um eine Vielzahl von Ge-Photodioden bereitzustellen, die auf jeweiligen Pyramidenoberteilen gebildet sind, um ein Focal-Plane-Array (FPA) (100) zu bilden.

2. Lichtdetektionsstruktur (100) nach Anspruch 1, wobei die Ge-Photodiode einen pn-Übergang beinhaltet.

3. Lichtdetektionsstruktur (100) nach Anspruch 1, wobei die Ge-Photodiode einen p-i-n-Übergang beinhaltet.

4. Lichtdetektionsstruktur (100) nach Anspruch 1, wobei der Pyramidenboden ein Quadrat von etwa 10 x 10 µm² ist.

5. Lichtdetektionsstruktur (100) nach Anspruch 1, wobei der Pyramidenoberteil ein Quadrat von etwa 1 x 1 µm² ist.

6. Lichtdetektionsstruktur (100) nach Anspruch 1, wobei der Pyramidenboden ein Quadrat von etwa 10 x 10 µm² ist und wobei der Pyramidenoberteil ein Quadrat von etwa 1 x 1 µm² ist.

7. Lichtdetektionsstruktur (100) nach Anspruch 1, wobei der SWIR-Bereich einen Wellenlängenbereich von etwa 1000nm bis etwa 1700nm beinhaltet.

8. Lichtdetektionsstruktur nach Anspruch 1, weiter umfassend eine Anordnung von Mikrolinsen (110), die zwischen den Pyramidenböden und dem einfallenden Licht platziert sind.

9. Lichtdetektionsstruktur (100) nach Anspruch 8, weiter umfassend eine Antireflexionsschicht (122), die zwischen dem Pyramidenboden und der Anordnung von Mikrolinsen (110) positioniert ist.

10. Lichtdetektionsstruktur (100) nach einem der vorstehenden Ansprüche, wobei die Größe der Ge-Photodiode im Vergleich zur Si-Pyramidenbasis klein ist.

11. Verfahren zur Bildung einer Lichtdetektionsstruktur, wobei das Verfahren umfasst:
a) Bilden einer Silizium (Si)-Basis (108), die eine Pyramidenform mit einem breiten, dem einfallenden Licht zugewandten Pyramidenboden und einem schmaleren Pyramidenoberteil aufweist; und
b) Bilden einer Germanium-, (Ge)-Photodiode (120) nur auf dem Pyramidenoberteil, wobei die Ge-Photodiode betreibbar ist, um Licht im kurzwelligen Infrarotbereich (SWIR) zu detektieren;
c) Bereitstellen einer Vielzahl von räumlich wiederholten Ge-Photodioden (120), die auf jeweiligen Pyramidenoberteilen gebildet sind, um ein Focal-Plane-Array (FPA) (100) zu bilden.

12. Verfahren nach Anspruch 11, wobei das Bilden einer Ge-Photodiode (120) nur auf dem Pyramidenoberteil Bilden einer Ge-Photodiode beinhaltet, wobei die Größe der Ge-Photodiode (120) im Vergleich zu jener des Si-Pyramidenbodens klein ist.

13. Verfahren nach Anspruch 11, weiter umfassend Platzieren einer Anordnung von Mikrolinsen (110) unterhalb der Pyramiden.

## Revendications

1. Structure de détection de lumière (100) comprenant :
a) une base (108) de silicium (Si) présentant une forme pyramidale avec un large fond de pyramide orienté vers la lumière entrante et un sommet de pyramide plus étroit ; et
b) une photodiode (120) de germanium (Ge) formée uniquement sur le sommet de pyramide, dans laquelle la photodiode de Ge peut fonctionner pour détecter de la lumière dans la gamme infrarouge à courte longueur d'onde (SWIR) ;
dans laquelle la structure de détection de lumière est répétée spatialement pour fournir une pluralité de photodiodes de Ge formées sur des sommets de pyramide respectifs pour former un réseau de plan focal (FPA) (100).

2. Structure de détection de lumière (100) selon la revendication 1, dans laquelle la photodiode de Ge inclut une jonction p-n.

3. Structure de détection de lumière (100) selon la revendication 1, dans laquelle la photodiode de Ge inclut une jonction p-i-n.

4. Structure de détection de lumière (100) selon la revendication 1, dans laquelle le fond de pyramide est un carré d'environ 10 x 10 µm².

5. Structure de détection de lumière (100) selon la revendication 1, dans laquelle le sommet de pyramide est un carré d'environ 1 x 1 µm².

6. Structure de détection de lumière (100) selon la revendication 1, dans laquelle le fond de pyramide est un carré d'environ 10 x 10 µm² et dans laquelle le sommet de pyramide est un carré d'environ 1 x 1 µm².

7. Structure de détection de lumière (100) selon la revendication 1, dans laquelle la gamme SWIR inclut une gamme de longueurs d'onde d'environ 1000 nm à environ 1 700 nm.

8. Structure de détection de lumière selon la revendication 1, comprenant en outre un réseau de microlentilles (110) placées entre les fonds de pyramide et la lumière entrante.

9. Structure de détection de lumière (100) selon la revendication 8, comprenant en outre une couche anti-reflet (122) positionnée entre le fond de pyramide et le réseau de microlentilles (110).

10. Structure de détection de lumière (100) selon l'une quelconque des revendications précédentes, dans laquelle la taille de la photodiode de Ge est petite par rapport à la base de pyramide de Si.

11. Procédé de formation d'une structure de détection de lumière, le procédé comprenant :
a) la formation d'une base (108) de silicium (Si) présentant une forme pyramidale avec un large fond de pyramide orienté vers la lumière entrante et un sommet de pyramide plus étroit ; et
b) la formation d'une photodiode (120) de germanium (Ge) uniquement sur le sommet de pyramide, dans laquelle la photodiode de Ge peut fonctionner pour détecter de la lumière dans la gamme infrarouge à courte longueur d'onde (SWIR) ;
c) la fourniture d'une pluralité de photodiodes de Ge (120) spatialement répétées formées sur des sommets de pyramide respectifs pour former un réseau de plan focal (FPA) (100).

12. Procédé selon la revendication 11, dans lequel la formation d'une photodiode de Ge (120) uniquement sur le sommet de pyramide inclut la formation d'une photodiode de Ge dans laquelle la taille de la photodiode de Ge (120) est petite par rapport à celle du fond de pyramide de Si.

13. Procédé selon la revendication 11, comprenant en outre le placement d'un réseau de microlentilles (110) sous les pyramides.
